# EUROPEAN PATENT APPLICATION

(11) **EP 4 741 170 A1**
(43) Date of publication of application: **13.05.2026**
(21) Application number: 25208160.9
(22) Date of filing: 11.10.2025
(51) Int. Cl.: B41N 1/24, B41C 1/14

(54) **FOIL FOR A PRINTING SCREEN, PRINTING SCREEN AND METHODS FOR MAKING THE FOIL AND THE SCREEN**

(30) Priority: 06.11.2024 GB 202416373
(71) Applicant: ASMPT SMT Singapore Pte. Ltd., Singapore 768924 (SG)
(72) Inventor: WALKER, William, Sudbury, CO10 7JN (GB); ASHMORE, Clive, Weymouth, DT4 9DY (GB)
(74) Representative: Emerson, Peter James

(57) **Abstract**

A printing screen for SMT applications at least partially comprising graphene, optionally in the form of carbon nanotubes.

## Description

This invention relates to a foil for a printing screen, a printing screen, a method of making a foil and a method of making a printing screen.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a thin planar layer or mask, such as a stencil or a screen.

A stencil is a patterned solid material, such as stainless steel, nickel or, less commonly, plastics material, in the form of a substantially planar sheet which includes apertures which define the pattern to be printed. For the sake of understanding, such a sheet is commonly referred to as a "foil" if it has not yet had apertures formed in it (see below). Stencils are used to print directly onto a PCB (on-contact printing). An image in a stencil consists of apertures (laser-cut, chemically etched, or electroformed) which extend through the sheet.

A screen meanwhile is a mesh material comprising a flexible, perforate sheet, for example a woven mesh of polypropylene, polyester or stainless steel strands. This mesh is then coated with emulsion and the image is then exposed with a camera or light source. Screens have a bit of separation (off-contact printing) with the workpiece, allowing the mesh to contact the printed surface as the squeegee passes.

Generally, a stencil may produce higher quality print results than a screen, however screens have benefits including reusability and the ability to print features such as long lines (which may be required for solar panel manufacture for example) or annuli, which stencils cannot achieve.

The present invention is equally applicable to both screen and stencil printing, and indeed provides for a hybrid of these, and for convenience the term "printing screen" will be used to refer to any such patterned mask throughout the remainder of this document. The term "foil" will be used to describe an unpatterned sheet which may be provided with apertures to form a printing screen. Importantly, the term "foil" will encompass both a continuous sheet of material, and a mesh sheet, for example, but not exclusively, formed by weaving strands together.

In both forms it is necessary to hold the printing screen under tension, and conventionally this is achieved by removably attaching the printing screen to a rectangular tensioning frame. The print medium is applied using an angled blade or squeegee. The same machines may also be used to print certain non-conductive media, such as glue or other adhesive, onto workpieces.

However, as noted above, while stencils may provide high quality print results, so that very fine features may be printed, it is not possible to use a stencil to print certain types of feature, such as the long lines or annuli previously mentioned. In addition, even current stencils face limits as to the minimum size of features they may reliably print. Generally, the smaller the feature, the thinner the stencil required, which clearly will reduce its strength.

The present invention seeks to overcome the above problems, and provide vastly improved printing screens which maintain high strength even at very low thicknesses. Furthermore, the proposed printing screens may be used to combine the features of stencils and screens, producing a "hybrid" printing screen enabling all types of features to be printed, at high quality.

In accordance with the present invention this aim is achieved by forming the sheet of the printing screen at least partially from graphene, a material which has not previously been proposed for such applications, nor has it been known how such a material could be used for such an application.

### Summary of the Invention

In accordance with a first aspect of the present invention there is provided a foil for a printing screen, comprising graphene.

In accordance with a second aspect of the present invention there is provided a printing screen comprising the foil of the first aspect.

In accordance with a third aspect of the present invention there is provided a method of making a foil for a printing screen, by forming a sheet of material comprising graphene.

In accordance with a fourth aspect of the present invention there is provided a method of making a printing screen, comprising the steps of:
i) making a foil using the method of the third aspect; and
ii) forming at least one aperture in the foil.

Other specific aspects and features of the present invention are set out in the accompanying claims.

### Brief Description of the Drawings

The invention will now be described with reference to the accompanying drawings (not to scale), in which:
FIG. 1A schematically shows, in perspective view, a printing screen according to the present invention;
FIG. 1B schematically shows, in section, a portion of the printing screen of FIG. 1A;
FIG. 2 schematically shows, in section, a portion of a printing screen according to a second embodiment of the present invention;
FIG. 3 schematically shows, in section, a portion of a printing screen according to a third embodiment of the present invention;
FIG. 4 schematically shows, in section, a portion of a printing screen according to a fourth embodiment of the present invention;
FIG. 5 schematically shows, in section, a portion of a printing screen according to a fifth embodiment of the present invention;
FIG. 6 schematically shows, from above, a portion of a printing screen according to a sixth embodiment of the present invention;
FIG. 7 schematically shows, from above, a printing screen according to a seventh embodiment of the present invention;
FIG. 8 schematically shows, in section, a portion of a printing screen according to an eighth embodiment of the present invention;
FIGs. 9 and 10 schematically shows, from above, printing screens according to further embodiments of the present invention;
FIG. 11 schematically shows, in section, a portion of a printing screen according to a yet further embodiment of the present invention;
FIG. 12 schematically shows, from above, a foil according to an embodiment of the present invention;
FIG. 13 schematically shows, in section from the side, a portion of the foil of FIG. 12 attached to an edge member; and
FIG. 14 schematically shows, in section from the side, a portion of a foil being attached to an edge member according to another embodiment of the present invention.

### Detailed Description of the Preferred Embodiments of the Invention

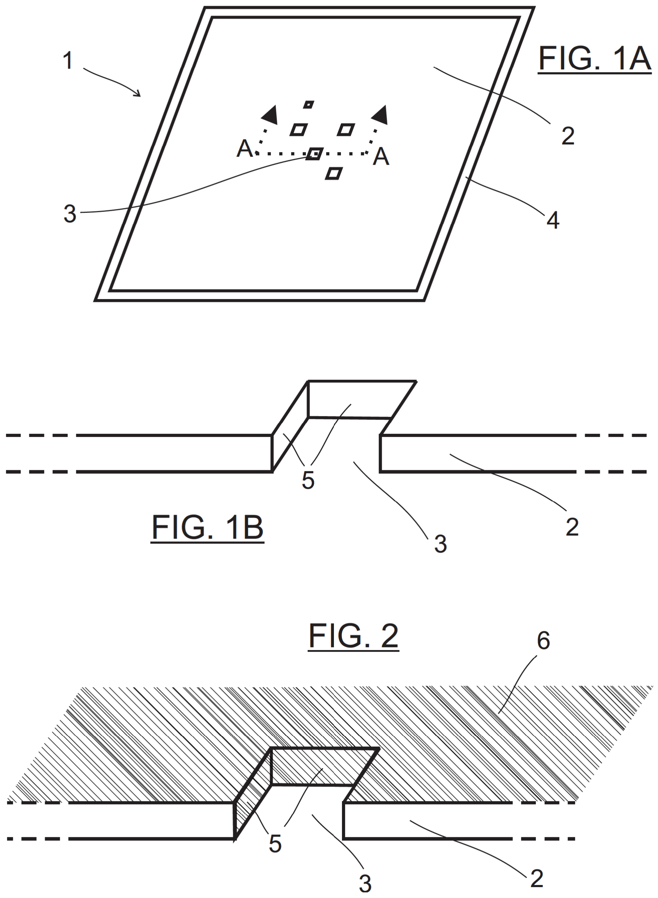

A printing screen 1 according to a first embodiment of the present invention is schematically shown in FIGs. 1A and 1B, with FIG. 1B showing an enlarged sectional view of a portion of the printing screen 1 in the direction A-A shown in FIG. 1A. The printing screen 1 shown is of the stencil type, and so comprises a stencil 2, which is a thin, flexible sheet, here of rectangular shape with two major rectangular surfaces, at its upper side and under side (not visible in FIG. 1A) respectively. A pattern of apertures 3 are formed in the stencil 2 and extend completely through the thickness of the stencil 2, as more clearly shown in FIG. 1B. In order to aid handling of the printing screen 1, the stencil 2 is bounded by a frame 4, as is well-known in the art per se. The frame 4 is preferably equipped with means (not shown) allowing engagement with an external tensioning frame (again not shown), such as the 'Vectorguard' (RTM) tensioning frame produced by ASMPT, so that the stencil may be tensioned prior to its use in a printing operation.

In accordance with the present invention, the stencil 2 comprises graphene. This may for example be a sheet of doped or undoped (i.e. pure) graphene. If the graphene is doped with a dopant material, then this may comprise materials such as fluorine and / or nitrogen for example. Suitable concentrations for such dopants may lie in the range of 0.5% to 6% by atomic percentage, optionally within the range 2% to 4% by atomic percentage, optionally about 3.5% by atomic percentage. Using such dopants may be especially beneficial for changing and optimising electrical properties of the graphene sheet. In a preferred embodiment, the doped or undoped graphene may be at least partially in the form of carbon nanotubes, which has been found to provide particularly high tensile strength. The use of such graphene materials provides various benefits over conventional metal or plastics stencils. In particular, graphene is much stronger than such materials, and so it is possible to form the sheet very thinly while retaining sufficient strength to withstand damage during a printing operation. It has been found that the quality of a printed deposit is highly dependent on the 'area ratio' of an aperture, i.e. the ratio of its open area to the area of its side walls 5. Having a much thinner sheet than conventionally possible therefore means that correspondingly smaller apertures may be used for effective printing. In addition, graphene is by its nature hydrophobic, and so may be readily cleaned of print material as required.

Apertures 3 may be formed in a blank foil of the graphene sheet, to produce the patterned stencil 2, in a variety of ways. For example, the apertures 3 may be formed by a process selected from the group consisting of laser-cutting, etching and milling. It has been found that a particularly advantageous technique is to use a femtosecond laser to ablate the graphene material and create the apertures 3.

As noted above, graphene is naturally hydrophobic. However, this property may be further enhanced by coating the patterned stencil 2 with a hydrophobic and oleophobic coating, such as, for example, the 'NanoUltra Gold' or 'Nanoclear' coatings available from ASMPT. This is schematically shown in FIG. 2, in a view similar to that of FIG. 1B, where a coating 6 has been applied to at least one major surface of the stencil 2. It can be seen that the coating 6 also covers the side walls 5 of the aperture 3.

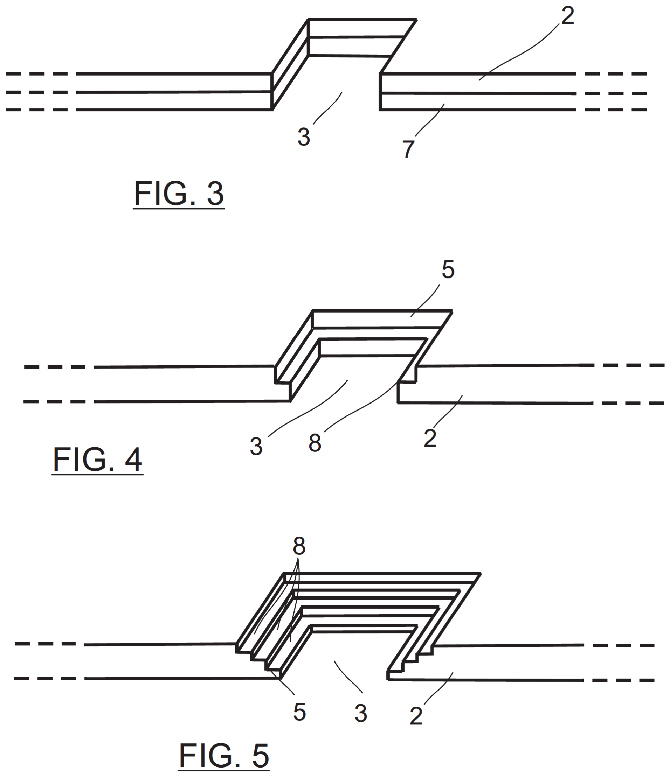

A third embodiment of the present invention is schematically shown in FIG. 3, in a view similar to that of FIG. 1B. As shown, the graphene sheet of stencil 2 is affixed to layer of a base material 7, the base material being different to graphene. The base material 7 may for example comprise one of the group consisting of nickel, stainless steel and alloys of nickel and stainless steel. The layer may be affixed to the sheet in various ways, including using adhesive or boding, or alternatively metal base materials may be electrically deposited onto the sheet, or by sputtering for example. This arrangement may be beneficial where, for example, the electrical properties of the stencil require control, or for use with particular print materials.

While FIG. 3 shows one layer of base material 7 being present, it is equally possible to provide and attach additional layers of base material. Furthermore, one or more additional sheets comprising graphene may be provided and attached to any other layer or sheet.

A fourth embodiment of the present invention is schematically shown in FIG. 4, in a view similar to that of FIG. 1B. As shown, the aperture 3 is stepped, i.e. the side walls 5 are not flat, but rather include a step 8. As shown therefore, the aperture 3 has a perimeter at one side (i.e. the upper side as shown) of the sheet which is greater than its perimeter at the other side of the sheet. This may be achieved in various ways such as, for example, forming a first aperture in the sheet having a first size, then adding a layer of material onto the sheet, similarly as described above in respect of FIG. 3, the layer comprising a second aperture having a second size, different from the first size, so that the first aperture and the second aperture at least partially overlap. Here, both the sheet and the added layer may comprise graphene.

Alternatively, the stepped formation may be produced by using a laser, such as a femtosecond laser, to form an aperture 3 extending through the sheet, with the stepped formation directly produced by the laser. For example, the stepped portion may be produced by performing one or more passes of the laser beam across the aperture area, with the central part of the aperture subjected to at least one additional pass. Such stepped formations may be formed on either side or both sides of the graphene sheet.

A fifth embodiment of the present invention is schematically shown in FIG. 5, in a view similar to that of FIG. 1B, which extends the aperture-shaping described with respect to FIG. 4. Here, the aperture 3 again has a perimeter at one side (i.e. the upper side shown) of the sheet which is greater than its perimeter at the other side of the sheet. In this example though, the aperture 3 is 'ramped', so that the side walls 5 have a more gradual slope than with the basic stepped formation of FIG. 4. This is achieved by providing a plurality of steps 8 at each side wall 5, each step 8 being shallower than that of FIG. 4. As shown, three steps are provided in each side wall 5. Such a ramped aperture 3 may be directly produced by a laser, such as a femtosecond laser, to ablate the graphene sheet. Similarly as described above with reference to FIG. 4, this may be achieved by applying successively greater numbers of passes with the ablating laser at regions closer to the centre of the aperture 7. Such ramped formations may be formed on either side or both sides of the graphene sheet.

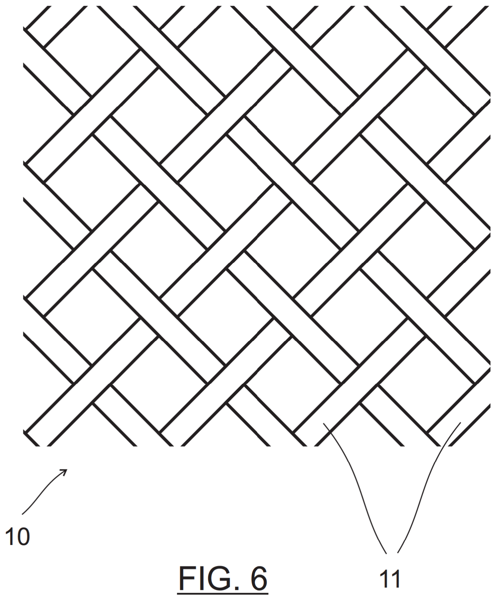

A portion of a printing screen 10 according to a sixth embodiment of the present invention is schematically shown, from above, in FIG. 6. Printing screen 10 is of the screen-type, i.e. it is formed of a woven mesh of strands 11, where each strand comprises graphene. Similarly to the previous embodiments, the graphene may be doped or undoped, coated or uncoated, and may advantageously comprise carbon nanotubes.

This type of screen may be used in a similar way to existing screens, with an aperture pattern formed by covering the strands 11 with emulsion (not shown), and then removing portions of the emulsion as required.

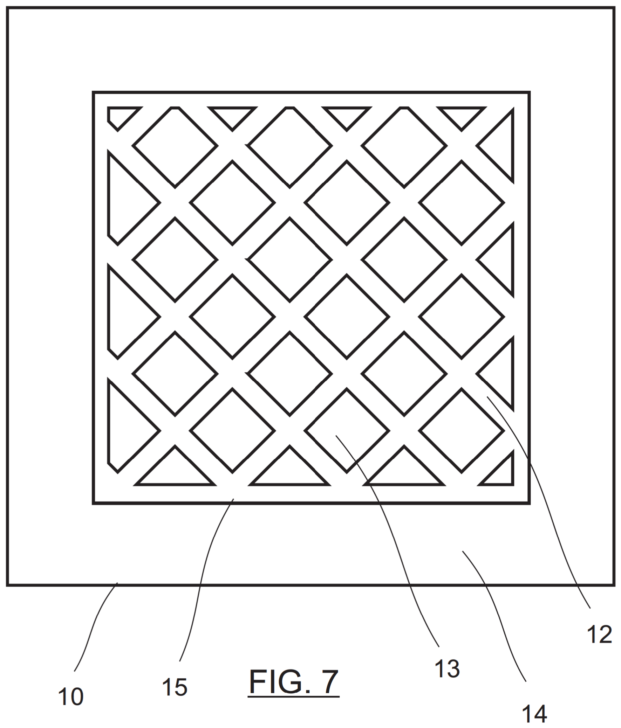

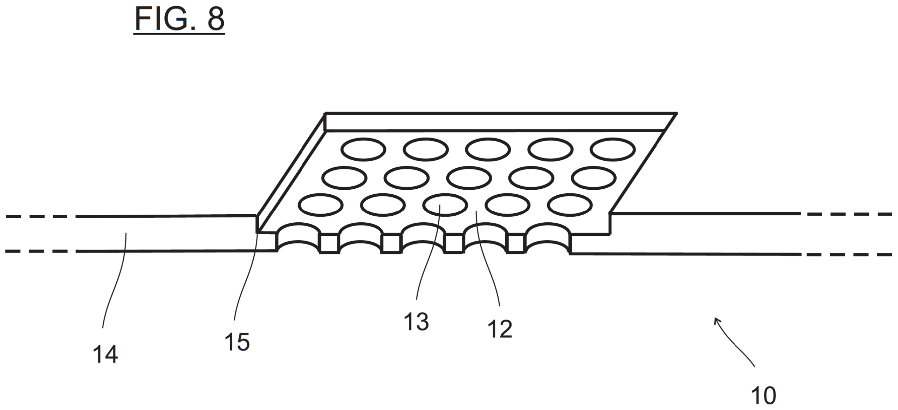

FIG. 7 schematically shows, from above, a printing screen 10 according to a seventh embodiment of the present invention, comprising a graphene sheet 14. This printing screen 10 includes a mesh area 12, so that the printing screen 1 may be used in place of a conventional screen. In this embodiment however, the mesh area 12 is formed by directly creating a plurality of apertures 13 in a regular array using a laser, such as a femtosecond laser, to ablate the apertures 13. One embodiment (not shown), the mesh area could cover substantially the entirety of the graphene sheet 14. As shown however, the mesh area 12 is formed only in a central region of the graphene sheet 14. The strands of the mesh are 12 made thinner than the graphene sheet 14 (as more clearly shown in FIG. 8) by removing material from the mesh area so that the thickness of graphene material at the mesh area is reduced, preferably by ablating large portions of the graphene sheet 14 to create a step 15 between the normal thickness of the graphene sheet 14 and the mesh area 12. For use of the printing screen 1, emulsion could be applied and patterned in the conventional way.

While the printing screen 10 of FIG. 7 only has a single, centrally arranged mesh area 12, the invention is not so limited, and there may be additional mesh areas provided within the printing screen, of nearly any shape, including relatively complex geometries.

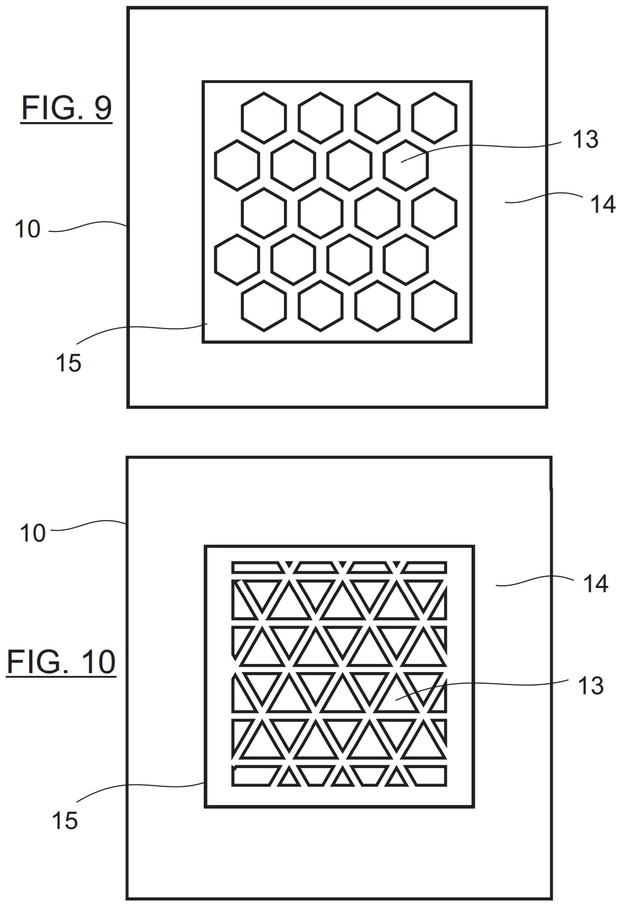

Using a laser to directly create the apertures of the mesh area means that these can be made of various shapes. By way of example, FIG. 8 schematically shows a printing screen 10 in which the apertures 13 are circular, FIG. 9 schematically shows a printing screen 10 in which the apertures 13 are hexagonal, while FIG. 10 schematically shows a printing screen 10 with triangular apertures 13. FIG. 8 shows a printing screen 10 in section, so that the step 15, and reduced thickness of the mesh area 12, are more clearly visible.

While the embodiments shown in FIGs. 7 to 10 use a single shape for each aperture 13, using a laser to create these apertures offers the freedom to combine different shape apertures as required within either the same mesh area, or within different mesh areas within the same printing screen.

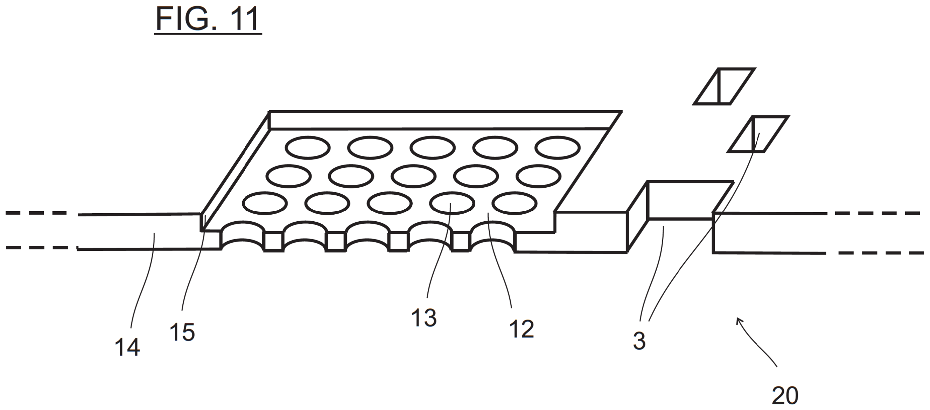

FIG. 11 schematically shows, in section, a portion of a printing screen 20 according to a yet further embodiment of the present invention. This printing screen 20 is a hybrid construction, effectively combining screen and stencil-type variants into a common printing screen. At least one mesh area 12 is provided as described previously with respect to FIGs. 7 to 10, while apertures 3 are also provided within the graphene sheet 14. Using such a hybrid printing screen enables 'difficult' deposits, such as annuli, to be printed using apertures formed in emulsion (not shown) on the mesh area 12, while 'standard' deposits may be printed at high accuracy using the apertures 3 away from the mesh area 12.

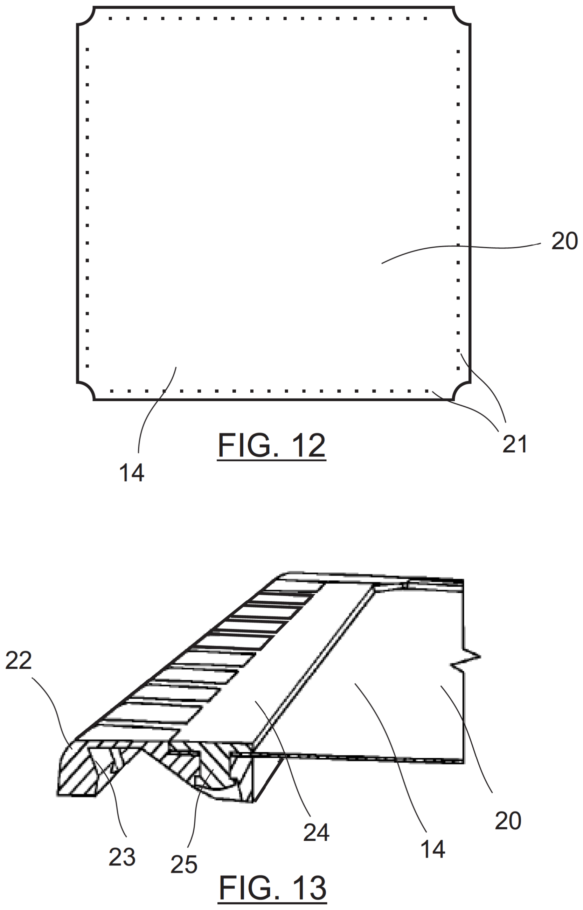

FIG. 12 schematically shows, from above, a foil 20 according to an embodiment of the present invention. The foil 20 comprises a graphene sheet 14 with attachment means, here comprising a plurality of openings 21, proximate each of its sides. The openings 21 extend completely through the thickness of the graphene sheet 14, and may be formed in a variety of ways, such as laser ablation, drilling or milling etc. The attachment means is used for connecting to an edge member 22 (see FIG. 13), which provides a protective finish and may also enable connection to an external tensioning frame (not shown).

FIG. 13 schematically shows, in section from the side, a portion of the foil 20 attached to an edge member 22. The edge member 22 may comprise a metal material such as aluminium, steel or the like, and extends the length of the respective side of the graphene sheet 14. It includes an engagement surface 23 for engagement with an external tensioning frame such as a Vectorguard (RTM) frame sold by ASMPT, and described in EP1499499B1. The graphene sheet 14 is clamped to the edge member 22 by a pin bar 24 which is similarly elongate to the edge member 22, and comprises a plurality of pins or fingers 25, each positioned and dimensioned so as to protrude through a respective opening 21 of the foil 20, and snap into engagement with a respective recess provided in the edge member 22. This type of connection is similar to the "Apshen" system sold by ASMPT and described in US9351406B2.

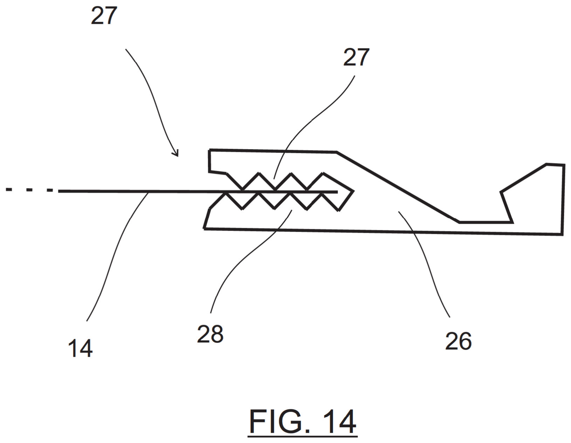

FIG. 14 schematically shows, in section from the side, a portion of a foil 27 being attached to an edge member 26, according to another embodiment of the present invention. Here, the edge member 26 is provided with two opposing toothed jaws 27, 28 at its inner edge (i.e. the edge closest to the centre of the foil 27 when attached), which are slightly spaced apart in an initial configuration as shown. In this initial configuration, the graphene sheet 14 of the foil 27 may be inserted between the jaws 27, 28, as shown in FIG. 14. The jaws 27, 28 are then pressed together to tightly grip the graphene sheet 14 therebetween, permanently attaching the edge member 26.

The above-described embodiments are exemplary only, and other possibilities and alternatives within the scope of the invention will be apparent to those skilled in the art.

### Reference numerals used:

1, 10, 20 - Printing screen
2 - Stencil
3 - Aperture
4 - Frame
5 - Aperture side walls
6 - Coating
7 - Base material
8, 15 - Step
11 - Strands
12 - Mesh area
13 - Apertures
14 - Graphene sheet
15 - Step
20, 27 - Foil
21 - Openings
22, 26 - Edge member
23 - Engagement surface
24 - Pin bar
25 - Finger
27, 28 - Jaws

## Claims

1. A foil for a printing screen, comprising graphene.

2. The foil of any claim 1, comprising a sheet of doped or undoped graphene; optionally the sheet is affixed to at least one layer of a base material, the base material being different to graphene; optionally the base material comprises one of the group consisting of nickel, stainless steel and alloys of nickel and stainless steel.

3. The foil of either of claims 1 and 2, wherein the graphene is at least partially in the form of carbon nanotubes.

4. The foil of any preceding claim, wherein the graphene is doped with a dopant material, optionally the dopant material comprises one of the group consisting of fluorine and nitrogen; optionally the dopant is provided at a concentration in the range of 0.5% to 6% by atomic percentage, optionally within the range 2% to 4% by atomic percentage, optionally about 3.5% by atomic percentage.

5. The foil of any preceding claim, comprising an edge member proximate each side of the foil; optionally the edge member comprises jaws which grip an edge of the foil.

6. The foil of claim 5, wherein the foil comprises a plurality of sides, with attachment means proximate each of its sides, each attachment means for connecting with an edge member in use; optionally the attachment means comprises openings formed proximate each of the sides of the foil; optionally the edge member comprises fingers which extend through respective openings.

7. A printing screen comprising the foil of any preceding claim, with at least one aperture formed in the foil and extending therethrough; optionally the printing screen comprises a plurality of apertures formed in a regular array to create a mesh area within the printing screen.

8. The printing screen of claim 7, wherein at least one aperture has a perimeter at one side of the printing screen which is greater than its perimeter at the other side of the printing screen.

9. A method of making a foil for a printing screen, by forming a sheet of material comprising graphene.

10. The method of claim 9, wherein the sheet comprises doped or undoped graphene; optionally the graphene is at least partially in the form of carbon nanotubes; optionally the method comprises doping the graphene with a dopant material; optionally the dopant material comprises one of the group consisting of fluorine and nitrogen.

11. A method of making a printing screen, comprising the steps of:
i) making a foil using the method of claim 9; and
ii) forming at least one aperture in the sheet.

12. The method of claim 11, wherein step ii) comprises forming the apertures by a process selected from the group consisting of laser-cutting (optionally using a femtolaser), etching and milling.

13. The method of either of claims 11 and 12, wherein step ii) comprises using a laser to form an aperture extending through the sheet, the aperture having a perimeter at one side of the sheet which is greater than its perimeter at the other side of the sheet.

14. The method of any of claims 11 to 13, comprising the steps of forming a first aperture in the sheet having a first size, then adding a layer of material onto the sheet, the layer comprising a second aperture having a second size, different from the first size, so that the first aperture and the second aperture at least partially overlap.

15. The method of any of claims 11 to 14, wherein step ii) comprises forming a plurality of apertures in a regular array to create a mesh area within the sheet; optionally comprising removing material from the mesh area so that the thickness of graphene material at the mesh area is reduced; optionally the method comprises applying an emulsion material to the mesh area, then forming a printing pattern by selectively removing regions of the emulsion material.
